# EUROPÄISCHE PATENTSCHRIFT

(11) **EP 2 191 324 B1**
(45) Veröffentlichungstag und Bekanntmachung des Hinweises auf die Patenterteilung: **05.04.2017**
(21) Anmeldenummer: 08801344.6
(22) Anmeldetag: 26.09.2008
(51) Int. Cl.: G02F 1/13357, H01L 33/00, G02B 6/00

(54) **LICHTEMITTIERENDES FLÄCHENELEMENT UND VERFAHREN ZUM HERSTELLEN EINES LICHTEMITTIERENDEN FLÄCHENELEMENTES**
LIGHT-EMITTING SURFACE ELEMENT AND METHOD FOR PRODUCING A LIGHT-EMITTING SURFACE ELEMENT
ÉLÉMENT DE SURFACE PHOTOÉMETTEUR ET PROCÉDÉ DE FABRICATION D'UN ÉLÉMENT DE SURFACE PHOTOÉMETTEUR

(30) Priorität: 28.09.2007 DE 102007046520
(43) Veröffentlichungstag der Anmeldung: 02.06.2010
(73) Patentinhaber: OSRAM Opto Semiconductors GmbH, 93055 Regensburg (DE)
(72) Erfinder: SORG, Jörg, 93053 Regensburg (DE); GRUBER, Stefan, 93077 Bad Abbach (DE)
(74) Vertreter: Epping - Hermann - Fischer
(86) Internationale Anmeldenummer: PCT/DE2008/001589
(87) Internationale Veröffentlichungsnummer: WO 2009/039846

(56) Entgegenhaltungen:
- EP-A- 1 367 655
- WO-A-2006/089540
- WO-A-2007/078103
- FR-A1- 2 518 317
- US-A1- 2005 117 334
- US-A1- 2005 264 194
- US-A1- 2006 250 800
- US-A1- 2007 053 179

## Beschreibung

Die Erfindung betrifft ein lichtemittierendes Flächenelement und ein Verfahren zum Herstellen eines lichtemittierenden Flächenelementes.
Lichtemittierende Flächenelemente haben in der jüngsten Vergangenheit an großer Bedeutung gewonnen. Nicht nur dort, wo Flächen zum Beispiel als Anzeigeelemente flächig zu beleuchten sind, sondern auch bei Displays verschiedenster Art, sind lichtemittierende Flächenelemente gewünscht. Dabei wird besonders Wert auf eine gleichmäßige Leuchtverteilung der lichtemittierenden Fläche Wert gelegt, damit alle Bereiche in gleichem Maße wahrgenommen werden. Es gibt seit längerer Zeit beispielsweise LCD-Monitor- beziehungsweise TFT-Displays, die eine flächige Durchleuchtung benötigen. Lichtquellen sind jedoch in der Regel punkt- beziehungsweise linienförmig, so dass das Licht für eine flächige Beleuchtung auf die Fläche verteilt werden muss. Hierzu sind flächige Lichtleiter bekannt, die durch eine entsprechende Oberflächenbehandlung angepasst an die Entfernung von der Lichtquelle das Licht aus dem Lichtleiter auskoppeln und zum Abstrahlen bringen.

Insbesondere aus Gründen der Energieeinsparung wird versucht für die Lichterzeugung übliche Halbleiterbauelemente zu verwenden, da diese einen hohen Wirkungsgrad aufweisen. Derartige Halbleiterbauelemente sind auch als LED bekannt.

Ein Lichtemittierendes Flächenelement gemäß des Oberbegriffs des Anspruchs 1 und dessen Herstellungsverfahren sind aus Dokument US 2007/0053179 A1 bekannt.

Aufgabe der Erfindung ist es ein lichtemittierendes Flächenelement und Verfahren zu dessen Herstellung vorzusehen, das mit hoher Zuverlässigkeit bei geringen Strahlungsverlusten herstellbar ist. Diese Aufgabe wird durch die in den nebengeordneten Patentansprüchen angegebenen Maßnahmen gelöst. Insbesondere durch das Herstellen des flächigen lichtleitenden Elementes im Spritzgießverfahren wird das lichterzeugende Element und die Anschlusseinrichtung in das lichtleitende Element eingebettet, so dass zum Einen sich durch das Vermeiden von aneinander stoßender Grenzflächen die Einkopplung von Licht in das lichtleitende Element mit hohem Wirkungsgrad ermöglicht ist und zum Anderen eine stabile Verbindung zwischen dem flächigen lichtleitenden Element und der Anordnung als Anschlusseinrichtung und lichterzeugendem Element ausgebildet werden kann.

Weitere vorteilhafte Ausgestaltungen sind in den untergeordneten Patentansprüchen angegeben.

Durch das Vorsehen des lichterzeugenden Elementes als "Chip Size Package" ist es möglich, das lichterzeugende Element leicht und unter Vermeidung von die Montage behindernden Bonddrähten zu montieren und eine freie Fläche zur Verfügung zu haben, über die die Einkopplung des Lichtes in das flächige lichtleitende Element erfolgt.

Durch das Vorsehen einer Leuchtdiode als lichterzeugendes Element, kann durch geeignete Wahl Licht in der gewünschten Farbe erzeugt werden, so dass unterschiedliche farbig leuchtende Flächen mit dem gleichen flächigen lichtleitenden Element erzielbar sind und nur eine entsprechende Leuchtdiode gewährt werden muss.

Durch das Auftragen eines Konversionsmittels auf der als "Chip Size Package" auf der Anschlusseinrichtung montierten Leuchtdiode ist die montierte Anordnung vor Beeinträchtigungen während des Spritzgießens geschützt. Weiterhin kann somit die Farbgebung zu einem sehr späten Produktionszeitpunkt bestimmt werden.

Nachfolgend wird die Erfindung unter Bezugnahme auf die Zeichnung anhand von Ausführungsbeispielen beschrieben. Gleiche Bezugszeichen geben dabei gleiche Elemente in den einzelnen Figuren an, es sind dabei jedoch keine maßstäblichen Bezüge dargestellt.

Es zeigen:
Figur 1 ein lichtemittierendes Flächenelement in einer Ausschnittsseitenansicht,
Figur 2 das in Figur 1 dargestellte lichtemittierende Flächenelement um 90 Grad gedreht in einer Ausschnittsansicht,
Figur 3 eine Draufsicht auf die Anordnung von Leuchtdioden auf bandförmiger Anschlusseinrichtung,
Figur 4 eine schematische Darstellung eines lichtemittierenden Flächenelementes mit mehreren Leuchtdioden,
Figur 5 das in Figur 3 dargestellte Bandmaterial von flächigem lichtleitendem Element umspritzt, und
Figur 6 eine Variante der in Figur 1 dargestellten Ausgestaltung.

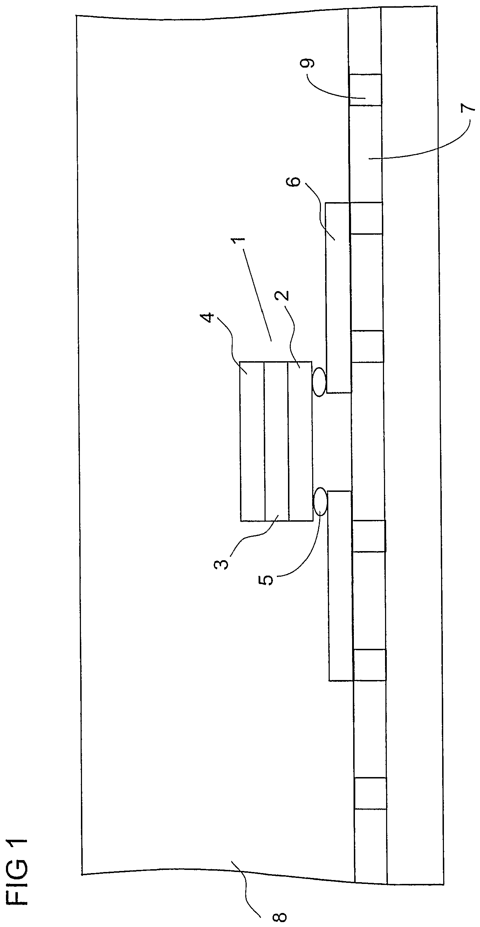

Figur 1 zeigt ein Ausführungsbeispiel, bei dem ein flexibles Bandmaterial 7 vorgesehen ist, das in konstantem Abstand Durchgangsöffnungen 9 aufweist. Auf dem Bandmaterial 7 sind Leiterbahnen 6 aus elektrisch leitendem Material aufgebracht. Dieses Aufbringen kann zum Beispiel mittels Drucktechnik oder durch Auflaminieren erfolgen. Dabei kann sowohl zunächst ganzflächig die Leiterbahn 6 aufgetragen und anschließend beispielsweise mittels eines Ätzverfahrens die gewünschte Form erhalten oder gleich in der gewünschten Form aufgetragen werden. Für letzteres empfiehlt sich insbesondere die Drucktechnik.

Des weiteren ist ein lichterzeugendes Element wie beispielsweise eine LED 3 vorgesehen, die als so genanntes "Chip Size Package" oder auch CSP 1 genannt ausgebildet ist. Dabei besteht dieses CSP 1 aus einem Träger 2, auf dem die LED 3 ausgebildet ist. Auf dem Träger 2 ist, im Detail nicht dargestellt, die Anschlusskontaktierung der LED 3 vorgesehen. Der Träger 2 weist wiederum Anschlusskontakte auf, die beispielsweise über flexible Bumps 5 mit den Leiterbahnen 6 verbunden sind. Im Betrieb soll die LED 3 nunmehr von der dem Träger 2 abgewandten Seite sichtbare elektromagnetische Strahlung aussenden.

Als Option ist vorgesehen, auf dieser das Licht abstrahlenden Fläche eine Konversionsschicht 4 aufzutragen, die die Farbgebung des Lichtes verändert. Dies bedeutet, dass die Wellenlänge des abgestrahlten Lichtes in ein Licht mit einer anderen Wellenlänge gewandelt wird. Auf diese Weise kann beispielsweise mit hohem Wirkungsgrad von einer LED abgestrahltes blaues Licht in weißes Licht gewandelt werden.

Die bis hierher beschriebene Anordnung aus CSP 1 und mit Leiterbahn 6 versehenem Bandmaterial 7 ist nunmehr von einem flächigen lichtleitenden Element 8 umgeben, so dass diese Anordnung in dem flächigen lichtleitenden Element 8 eingebettet ist. Diese Einbettung erfolgt vorzugsweise in der Form, dass die vormontierte Anordnung aus CSP 1 und Bandmaterial 7 in eine Spritzgießform eingebracht wird und die Spritzgießform sodann von einem thermoplastischen Material ausgefüllt wird. Während des Spritzgießens durchdringt das thermoplastische Material auch die Durchgangsöffnungen 9, so dass es nach dem Erhärten zu einer innigen und stabilen Verbindung zwischen dem flächigen lichtleitenden Element 8 und dem Bandmaterial 7 kommt.

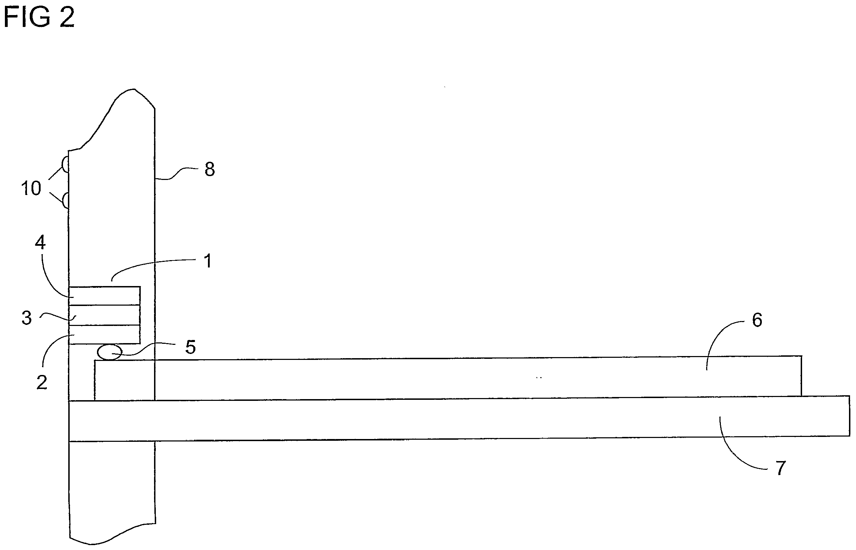

Figur 2 zeigt diese Anordnung noch einmal um 90 Grad gedreht. Dabei ist zu erkennen, dass das flächige lichtleitende Element 8 in etwa die Dicke des CSP 1 aufweist. Inwieweit das flächige lichtleitende Element 8 auf der dem CSP abgewandten Seite des Bandmaterials 7 weiterreicht hängt allein von mechanischen Vorraussetzungen ab.

Da das Licht von Seite der LED 3 abgestrahlt wird, die dem Träger abgewandt ist, erfolgt keine Ausbreitung und Weiterleitung des Lichtes unterhalb des Bandmaterials 7. Es kann jedoch aus Stabilitätsgründen oder aus Gründen der Formgebung gewünscht sein das gespritzte Material nicht nur bis zum Durchdringen des Bandmaterials sondern auch darüber hinaus vorzusehen, wie in den Figuren angedeutet ist.

An der Oberfläche des lichtleitenden flächigen Elementes 8 sind zwei kleine Erhöhungen 10 angedeutet. Diese sollen Flächengestaltungen andeuten, mit denen die Auskopplung des Lichtes erfolgt. Normal wird das Licht, das von der LED abgestrahlt wird in dem flächigen lichtleitenden Element 8 geführt und, so bald das Licht an die Außenkante stößt wieder nach innen reflektiert. Gelangt das Licht an Stellen, die mit dem Bezugszeichen 10 gekennzeichnet sind und die Oberfläche modulieren, erfolgt liegt ein veränderter Einfallswinkels für das von innen kommende Lichtes an der Oberfläche vor, so dass es nicht mehr nach innen reflektiert sondern nach außen emittiert wird. Auf diese Art und Weise kann durch eine entsprechende Gestaltung der Oberfläche die Emission an der Oberfläche des flächigen lichtleitenden Elementes eingestellt werden.

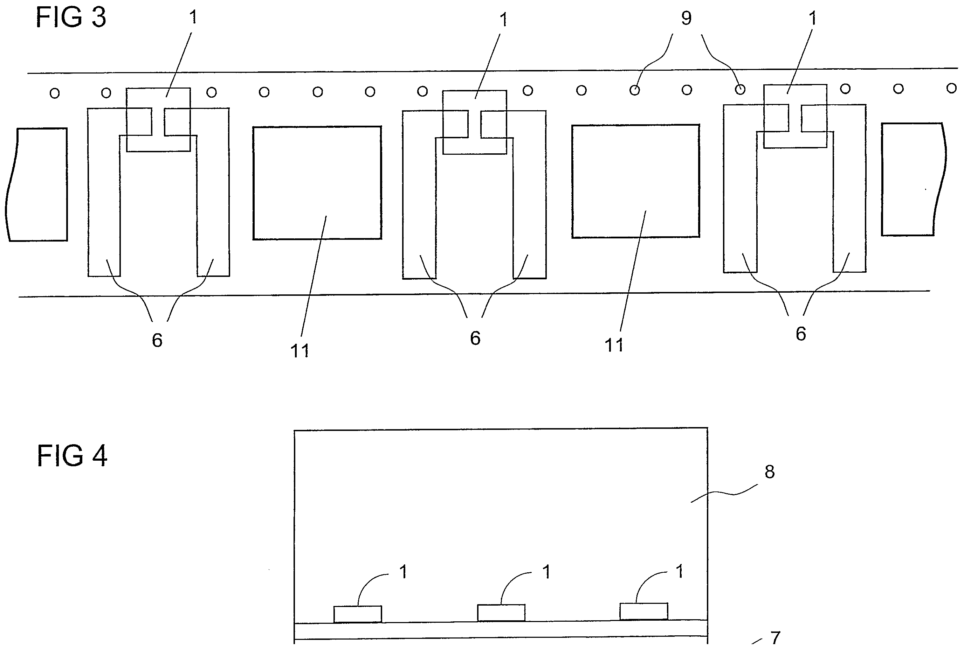

Figur 3 zeigt das Bandmaterial 7 mit den Durchgangsöffnungen 9 in der Draufsicht. In gleichmäßigen Abständen sind Leiterbahnen 6 paarweise geführt, die an der Stelle, an der ein CSP 1 zur Montage vorgesehen ist dichter aneinander geführt sind. Die Durchgangsöffnungen 9 sind über ihre in Bezugnahme auf Figur 1 und 2 beschriebene Funktion hinaus auch dann von Vorteil, wenn das Bandmaterial 7 von einer Rolle kommend bestückt wird und anschließend wieder aufgewickelt werden soll. Die Durchgangsöffnungen 9 können dann für einen exakten Transport beziehungsweise für eine exakte Positionierung des Bandes 7 verwendet werden. Dies gilt selbstverständlich auch dann, wenn das Bandmaterial 7 in die Spritzgießform eingebracht und dort positioniert wird. Die Fensteröffnungen 11 dienen dazu, dass beim Spritzgießen sich das flächige lichtleitende Element um das Bandmaterial 7 herum erstrecken kann und dabei, wie in Fig. 2 erkennbar ist, nur unwesentlich weiter über den CPS 1 hinausragt.

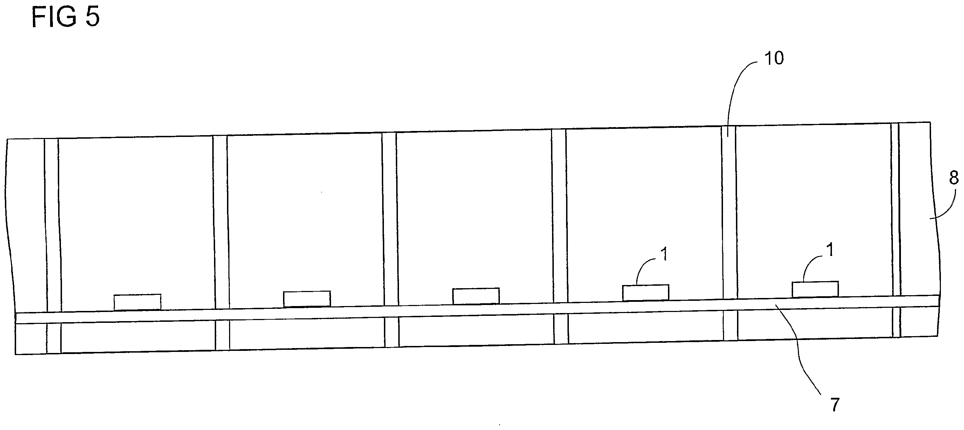

In Figur 5 ist diese mehr oder weniger endlose Anordnung aus Figur 3 in einer der Figur 1 entsprechenden Ansicht stärker vereinfacht dargestellt. Das flächige lichtleitende Element kann sozusagen entsprechend endlos wie das Band ausgebildet werden und in gewünschten Abständen zur Vereinzelung nach dem Erhärten abgetrennt werden. Gemäß Figur 5 ist jeweils mittig zwischen zwei CSPs 1 eine Trennlücke 10 dargestellt, entlang der das einzelne lichtemittierende flächige Element abgetrennt wird. Dies kann beispielsweise mit einem geeigneten Schneidverfahren geschehen.

Es ist jedoch auch denkbar, dass entweder jeweils eine Spritzgießform für ein einzelnes lichtemittierendes Flächenelement verwendet wird oder die Spritzgießform derart ausgestaltet ist, dass sie Verjüngungen oder Trennwände aufweist, so dass entsprechend an den Stellen, die in Figur 5 mit den Bezugszeichen 10 versehen sind, gegebenenfalls durch eine Abbrechen die einzelnen lichtemittierenden Flächenelemente vereinzelbar sind.

Es ist jedoch auch nicht zwingend notwendig, dass für jedes lichtemittierende Flächenelement nur ein einzelnes lichterzeugendes CSP 1 vorgesehen ist. Die Anzahl hängt letztendlich von der gewünschten Lichtstärke und der Größe der auszubildenden und auszuleuchtenden Fläche ab. Gemäß Figur 4 ist dies in der Form angedeutet, dass bei dem in Figur 4 dargestellten Ausführungsbeispiel drei CSP 1 gewählt sind.

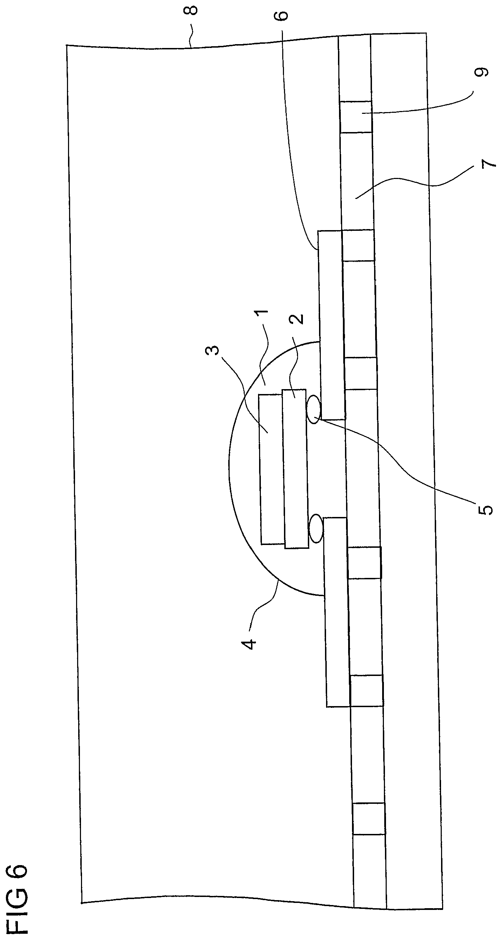

Unter Bezugnahme auf Figur 1 ist angegeben, dass auf der LED 3 eine Konversionsschicht 4 aufgetragen ist, um das von der LED erzeugte natürliche Licht in ein gewünschtes Licht zu konvertieren. In einer Ausgestaltung wie sie in Figur 6 dargestellt ist, ist die Anordnung nur insofern von der in Figur 1 dargestellten Anordnung verschieden, dass zunächst die Konversionsschicht 4 fehlt. Anstelle dessen ist ein Konversionsabdeckung 4a das CSP 1 umhüllend aufgetragen. Dies kann beispielsweise als Tropfen oder in einem Spritzverfahren aufgetragen werden. Welches Verfahren letztendlich gewählt wird hängt allein von den technischen Möglichkeiten ab und davon in welchem Zustand das CSP 1 vor der Montage auf dem Bandmaterial vorab getestet werden soll.

## Patentansprüche

1. Lichtemittierendes Flächenelement mit zumindest einem flächigen lichtleitenden Element (8), einer Anschlusseinrichtung (7, 6) und einem lichterzeugenden Element (1), wobei das lichterzeugende Element (1) zumindest zwei Anschlüsse (5) aufweist, die mit zugeordneten Anschlussleitungen (6) auf der Anschlusseinrichtung (7, 6) elektrisch leitend verbunden sind, und das flächige lichtleitende Element (8) im Spritzgießverfahren die Anordnung aus Anschlusseinrichtung (6, 7) und lichterzeugendem Element (1) einbettend ausgebildet ist, **dadurch gekennzeichnet, dass**
die Anschlusseinrichtung aus einem Bandmaterial (7) und auf dem Bandmaterial angeordneten Anschlussleitungen (6) ausgebildet ist und entlang einer Längserstreckung in regelmäßigen Abständen Öffnungen (9) aufweist, durch die das flächige lichtleitende Element (8) einstückig hindurchragt.

2. Lichtemittierendes Element nach Anspruch 1, bei dem das lichterzeugende Element (1) eine als "Chip Size Package" ausgebildete Leuchtdiode ist.

3. Lichtemittierendes Flächenelement nach Anspruch 2, bei dem das "Chip Size Package" (1) einen Träger (2) mit Anschlusselementen (5) und diesen gegenüberliegend auf dem Träger (2) einen mit den Anschlusselementen (5) elektrisch leitend verbundenen Leuchtdiodenchip (3) aufweist.

4. Lichtemittierendes Flächenelement nach einem der vorhergehenden Ansprüche, bei dem ein lichtemittierendes Gebiet des lichterzeugenden Elementes von einem Konversionsmittel (4; 4a) abgedeckt ist, welches das mit einer ersten Wellenlänge vom lichterzeugenden Element (1) abgestrahlte Licht in ein Licht einer davon verschiedenen Wellenlänge konvertiert.

5. Lichtemittierendes Flächenelement nach Anspruch 4, bei dem das Konversionsmittel (4) als eine Schicht ausgebildet ist, die das lichtemittierende Gebiet auf dem Chip (3) abdeckt.

6. Lichtemittierendes Flächenelement nach Anspruch 4, bei dem das Konversionsmittel (4a) das "Chip Size Package" (1) auf dem Träger abdeckend ausgebildet ist.

7. Lichtemittierendes Flächenelement nach einem der vorhergehenden Ansprüche, bei dem mehrere lichterzeugende Elemente (1) auf der Anschlusseinrichtung vorgesehen sind.

8. Verfahren zum Herstellen eines lichtemittierenden Flächenelementes, bei dem eine Anschlusseinrichtung (7, 6) bereitgestellt wird, auf der Anschlusseinrichtung (7, 6) ein lichterzeugendes Element (1) angeordnet wird und ein flächiges lichtleitendes Element (8) im Spritzgießverfahren derart hergestellt wird, dass das lichterzeugende Element (1) und die Anschlusseinrichtung (7, 6) zumindest teilweise in das lichtleitende Element (8) eingebettet sind, wobei die Anschlusseinrichtung (7, 6) aus einem Bandmaterial (7) mit auf dem Bandmaterial (7) angeordneten Anschlussleitungen (6) ausgebildet wird, wobei das Bandmaterial (7) entlang einer Längserstreckung in regelmäßigen Abständen Öffnungen (9) aufweist, durch die das flächige lichtleitende Element (8) einstückig hindurchragt.

9. Verfahren nach Anspruch 8, bei dem die Anschlusseinrichtung als "Endlos-Material" bereitgestellt wird und das einzelne lichtemittierende Flächenelement nach dem Aushärten der spritzgegossenen flächigen lichtleitenden Elemente vereinzelt wird.

## Claims

1. Light-emitting surface element comprising at least one planar light-guiding element (8), a connection device (7, 6) and a light-generating element (1), wherein the light-generating element (1) has at least two connections (5) which are electrically conductively connected to assigned connection lines (6) on the connection device (7, 6), and the planar light-guiding element (8) is formed by the injection-molding method in a manner embedding the arrangement composed of connection device (6, 7) and light-generating element (1), **characterized in that** the connection device is formed from a strip material (7) and connection lines (6) arranged on the strip material and has openings (9) at regular distances along a longitudinal extent, through which openings the planar light-guiding element (8) projects integrally.

2. Light-emitting element according to Claim 1, wherein the light-generating element (1) is a light-emitting diode formed as a "chip size package".

3. Light-emitting surface element according to Claim 2, wherein the "chip size package" (1) has a carrier (2) with connection elements (5) and lying opposite the latter on the carrier (2) a light-emitting diode chip (3) electrically conductively connected to the connection elements (5).

4. Light-emitting surface element according to any of the preceding claims, wherein a light-emitting region of the light-generating element is covered by a conversion means (4; 4a), which converts the light emitted with a first wavelength by the light-generating element (1) into a light having a wavelength different therefrom.

5. Light-emitting surface element according to Claim 4, wherein the conversion means (4) is formed as a layer covering the light-emitting region on the light-generating element (3).

6. Light-emitting surface element according to Claim 4, wherein the conversion means (4a) is formed in a manner covering the "chip size package" (1) on the carrier.

7. Light-emitting surface element according to any of the preceding claims, wherein a plurality of light-generating elements (1) are provided on the connection device.

8. Method for producing a light-emitting surface element, wherein a connection device (7, 6) is provided, a light-generating element (1) is arranged on the connection device (7, 6), and a planar light-guiding element (8) is produced by the injection-molding method in such a way that the light-generating element (1) and the connection device (7, 6) are at least partly embedded into the light-guiding element (8), wherein the connection device (7, 6) is formed from a strip material (7) having connection lines (6) arranged on the strip material (7), wherein the strip material (7) has openings (9) at regular distances along a longitudinal extent, through which openings the planar light-guiding element (8) projects integrally.

9. Method according to Claim 8, wherein the connection device is provided as "continuous material", and the individual light-emitting surface element is separated after the curing of the injection-molded planar light-guiding elements.

## Revendications

1. Elément bidimensionnel électroluminescent comportant au moins un élément photoconducteur plat (8), un dispositif de connexion (7, 6) et un élément générateur de lumière (1), dans lequel l'élément générateur de lumière (1) comporte au moins deux bornes (5) qui sont reliées de manière électriquement conductrice à des lignes de connexion associées (6) sur le dispositif de connexion (7, 6), et l'élément photoconducteur plat (8), dans le procédé de moulage par injection, est réalisé de manière à enrober l'agencement constitué du dispositif de connexion (6, 7) et de l'élément générateur de lumière (1),
**caractérisé en ce que** le dispositif de connexion est réalisé à partir d'un feuillard (7) et de lignes de connexion (6) disposées sur le feuillard et comporte, à des intervalles réguliers le long d'une extension longitudinale, des ouvertures (9) à travers lesquelles passe d'un seul tenant l'élément photoconducteur plat (8).

2. Elément électroluminescent selon la revendication 1, dans lequel l'élément générateur de lumière (1) est une diode électroluminescente réalisée sous la forme d'un "boîtier de la taille d'une puce" (Chip Size Package).

3. Elément bidimensionnel électroluminescent selon la revendication 2, dans lequel le "boîtier de la taille d'une puce" (1) comporte un support (2) ayant des éléments de connexion (5) et une puce de diode électroluminescente (3) opposée à ceux-ci sur le support (2), reliée de manière électriquement conductrice aux l'éléments de connexion (5).

4. Elément bidimensionnel électroluminescent selon l'une quelconque des revendications précédentes, dans lequel un domaine électroluminescent de l'élément générateur de lumière est recouvert d'un moyen de conversion (4 ; 4a) qui convertit la lumière rayonnée par l'élément générateur de lumière (1) à une première longueur d'onde en une lumière ayant une longueur d'onde différente de celle-ci.

5. Elément bidimensionnel électroluminescent selon la revendication 4, dans lequel le moyen de conversion (4) est réalisé sous la forme d'une couche qui recouvre le domaine électroluminescent sur le puce (3).

6. Elément bidimensionnel électroluminescent selon la revendication 4, dans lequel le moyen de conversion (4a) est réalisé de manière à recouvrir le "boîtier de la taille d'une puce" (1) sur le support.

7. Elément bidimensionnel électroluminescent selon l'une quelconque des revendications précédentes, dans lequel plusieurs éléments générateurs de lumière (1) sont prévus sur le dispositif de connexion.

8. Procédé de fabrication d'un élément électroluminescent bidimensionnel, dans lequel un dispositif de connexion (7, 6) est prévu, un élément générateur de lumière (1) est disposé sur le dispositif de connexion (7, 6) et un élément photoconducteur plat (8) est fabriqué dans le procédé de moulage par injection de manière à ce que l'élément générateur de lumière (1) et le dispositif de connexion (7, 6) soient noyés au moins partiellement dans l'élément photoconducteur (8), dans lequel le dispositif de connexion (7, 6) est réalisé à partir d'un feuillard (7) comportant des lignes de connexion (6) disposées sur le feuillard (7), dans lequel le feuillard (7) comporte, à des intervalles réguliers le long d'une extension longitudinale, des ouvertures (9) à travers lesquelles passe d'un seul tenant l'élément photoconducteur plat (8).

9. Procédé selon la revendication 8, dans lequel le dispositif de connexion est prévu sous la forme d'un "matériau sans fin" et l'élément bidimensionnel électroluminescent individuel est isolé après le durcissement de l'élément photoconducteur plat moulé par injection.
